# EUROPEAN PATENT SPECIFICATION

(11) **EP 0 685 742 B1**
(45) Date of publication and mention of the grant of the patent: **03.01.2001**
(21) Application number: 94108593.8
(22) Date of filing: 01.06.1994
(51) Int. Cl.: G01R 1/067, H01B 11/18

(54) **High speed coaxial contact and signal transmission element**
Schnelles Koaxialkontakt- und Signalübertragungselement
Elément de contact coaxial et de transmission de signaux à haute vitesse

(43) Date of publication of application: 06.12.1995
(73) Proprietor: International Business Machines Corporation, Armonk, N.Y. 10504 (US)
(72) Inventor: Stoehr, Roland, D-71154 Nufringen (DE); Kratt, Rudolf, D-72108 Rottenburg (DE)
(74) Representative: Schäfer, Wolfgang, Dipl.-Ing.

(56) References cited:
- EP-A- 0 222 119
- IBM TECHNICAL DISCLOSURE BULLETIN, vol.32, no.6A, November 1989, NEW YORK US pages 173 - 174 'Very High Speed Co-axial Cable'
- IBM TECHNICAL DISCLOSURE BULLETIN, vol.13, no.4, September 1970, NEW YORK US page 993 RYAN ET AL. 'AC/DC Coaxial Probe'
- IBM TECHNICAL DISCLOSURE BULLETIN, vol.20, no.4, September 1977, NEW YORK US pages 1522 - 1523 LOEFFEL ET AL. 'Probe for Circuit Module'

## Description

The invention relates to a high speed coaxial contact and signal transmission element. These elements are used for the transmission of high speed electrical signals in high density fashion and for contacting and testing electrical devices.

With the increasing miniaturization of electronic components there is a strong demand for adequate contact and signal transmission elements in the high frequency (GHz) range. Coaxial cables suitable for signal transmissions in the GHz range should have a diameter smaller than approximately 0.6 mm and an approximately 50-ohm or 70-ohm characteristic impedance.

A very high speed co-axial cable with a 50-ohm characteristic impedance is disclosed in IBM Technical Disclosure Bulletin Vol. 32, No. 6A, November 1989, p.173/174. In the construction of this co-axial cable two filaments of low dielectric porous material are spirally wrapped about the signal center conductor in counter-directions and at different wrapping rates. The different wrapping rates cause multiple crossings of the filaments to occur and thus create a stable symmetrical cross-section. in addition, this kind of wrapping guarantees the incorporation of a large fraction of air of low dielectric constant into the cross-section of the co-axial cable.

The forming of a radiation cable by winding at least two conductive tapes around a core having an inner conductor surrounded by a dielectric layer is described in US patent 4 432 193. Both tape widths and pitch angles can be varied along the cable length to give the desired cable characteristics like aperture shape, size and distribution along the cable length.

GB 1163308 discloses a coaxial cable with a balloon-type helical insulator which is made by forming a tube of plastics material about the inner conductor. After forming and inflating the tube is shaped by winding a single filament tightly around it thereby causing the tube to make contact with the inner conductor along a helical path. The capacity of the cable may be varied by regulating the pitch of the winding of the filament. The filament is removed after the tube has been set.

Known high speed coaxial probes for electrical device testing consist of probe tips that are attached to the coaxial cable. In IBM Technical Disclosure Bulletin Vol. 32, No. 8A, January 1990, p.133-135 a beryllium-copper tip with the tip end being 25 µm wide is attached to a semi-rigid coaxial cable and brings the signal to the pads on the device to be tested. Often there are used wire or needle probes coupled to a blade as disclosed in US 4 593 243. The needle or wire end is adapted to contact a conductive pad on a device to be tested. EPP Halbleiter Juli/August 1992, p. 50/51 describes the application of different blades like ceramic or metal blades with test needles and also the use of coaxial cables with needles for testing devices.

All these known coaxial elements thus have interfaces or interruptions between the coaxial cable and the electrical device to be tested and therefore impedance and contact resistance are negatively affected in that it causes problems especially in high frequency applications.

EP 0 222 119 A discloses a coaxial test probe with a flexible inner conductor housed in a conductive outer sheath.

It is an object of the present invention to provide a high speed coaxial contact and signal transmission element which may simultaneously be used as contact and signal transmission element. It is a further object to provide a high speed coaxial contact and signal transmission element which requires no interface between the high speed coaxial contact element and an electrical device to be tested by said high speed coaxial contact element. Still a further object is to provide a high speed coaxial element which shows very accurate signal transmission results.

These objects are achieved by the invention as claimed. Provided is a high speed coaxial contact and signal transmission element which comprises an inner conductor element, an outer conductor element and a dielectric area between said inner conductor element and said outer conductor element, wherein said inner conductor element is a continuous element and consists of a core of hardened conductive material exhibiting good elastic properties surrounded by a metal shell. A filament of low dielectric constant material is wrapped around said inner conductor element and fixed on the surface of the inner conductor element and said outer conductor element consists of a metal shield.

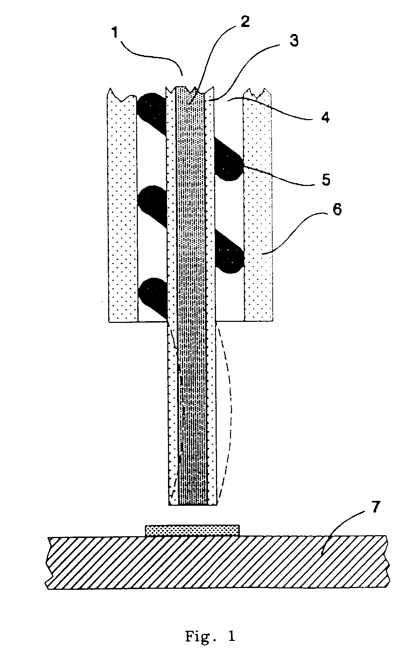

Ways of carrying out the invention are described in detail below with reference to a drawing, Fig.1, showing only one specific embodiment in which the cross-section of a high speed coaxial contact and signal transmission element is shown.

The inner conductor element 1 consists of a core 2 of hardened conductive material, e.g. CuBe2, which also exhibits good elastic properties. The diameter of the core 2 is in the range of smaller than approximately 0.060 mm. This core 2 is surrounded by a metal shell 3 comprising Ag and Cu to further enhance the conductance of the inner conductor element 1. Choosing different materials for the core 2 and the metal shell 3 easily allows defining suitable mechanical as well as electrical properties of the inner conductor element. Hardening of the core 2 material to approximately 1400 N/mm² or approximately 1600 N/mm² further enhances its conductance and its tension. The change of the electrical and mechanical properties of the inner conductor element 1 induced by the hardening step provides an inner conductor element which allows using this conductor element as a contact element. Due to its good elastic properties the inner conductor element is flexible as indicated by dashed lines in Fig. 1 and thus may easily contact e.g. the contact pad of a device to be tested.

The inner conductor element thus is a continuous element having no interfaces between the conductor element and a device to be contacted and tested. This is extremely important for high frequency applications when impedance is important. The core 2 being surrounded by a metal shell 3 offers further advantage especially for high frequency applications being influenced by the skin effect, since signal transmission at high frequencies takes place significantly in the surface area of a conductor.

The outer conductor element 6 consists of a metal shield, the metal preferably comprises Ag and Cu.

Between the inner conductor element 1 and the outer conductor element 6 there is a dielectric area 4. This dielectric area 4 has essential influence on the total diameter of the coaxial element depending on the dielectric constant of the dielectric material chosen. The best dielectric material is air with εᵣ = 1. Realizing a coaxial cable using only air as dielectric material is however not manufacturable. As shown in Fig.1 a filament 5 of low dielectric constant material is wrapped around the inner conductor element 1 and fixed on the surface of the inner conductor 1. The fixing of the filament 5 is important to avoid relative motions between the filament 5 and the inner conductor 1. Such motions could cause friction inducing electrostatic charging processes which could have impact on the signal transmission behaviour of the coaxial element. In a preferred embodiment the filament is spirally wrapped around the inner conductor element. The filament material chosen should have a very small dielectric constant. Suitable materials are e.g. polyimides, polytetrafluoroethylene (PTFE) and mineral fibers. The filament is preferably a monofilament of dielectric material, but it is also possible to wrap two or more fibers around the inner conductor element. By regulating the pitch of the winding of the filament the electrical properties of the coaxial element may be changed, especially the impedance of the coaxial contact and signal transmission element. Changing the pitch of the winding changes the εᵣ-ratio of air and filament in that with a reduced pitch the portion of air is reduced too.

The high speed coaxial contact and signal transmission element described above has a total diameter of smaller than approximately 0.6 mm and an impedance of approximately 50 ohm or approximately 70 ohm.

Thus it offers a broad spectrum of various applications for high frequency signal transmission and for contacting electronic devices with minimal dimensions, e.g.for testing with an array as disclosed in EP-A-0 283 545.

## Claims

1. A high speed coaxial contact and signal transmission element comprising:
- an inner conductor element (1),
- an outer conductor element (6) and
- a dielectric area (4) between said inner conductor element (1) and said outer conductor element (6), said outer conductor element (6) consisting of a metal shield, said inner conductor element (1) being a continuous element and comprising a core (2) of conductive material exhibiting good elastic properties, characterised in that said inner conductor consists of a core of hardened conductive material exhibiting good elastic properties surrounded by a metal shell (3), and that a filament (5) of low dielectric constant material is wrapped around said inner conductor element (1) and fixed on the surface of the inner conductor element (1).

2. The high speed coaxial contact and signal transmission element according to claim 1 wherein said coaxial contact and signal transmission element has a total diameter of smaller than 0.6 mm and an impedance of 50 ohm or 70 ohm.

3. The high speed coaxial contact and signal transmission element according to claim 1 or 2 wherein said inner conductor element (1) is suitable for directly contacting a device (7) to be tested by said high speed coaxial contact and signal transmission element.

4. The high speed coaxial contact and signal transmission element according to any of the preceding claims 1 to 3 wherein said continuous core (2) has a diameter of smaller than 0.060 mm.

5. The high speed coaxial contact and signal transmission element according to any of the preceding claims 1 to 4 wherein said continuous core (2) has a hardness in the range of 1400 N/mm² to 1600 N/mm².

6. The high speed coaxial contact and signal transmission element according to any of the preceding claims 1 to 5 wherein said hardened conductive material comprises CuBe2.

7. The high speed coaxial contact and signal transmission element according to any of the preceding claims 1 to 6 wherein said filament (5) is spirally wrapped around said inner conductor element (1).

8. The high speed coaxial contact and signal transmission element according to any of the preceding claims 1 to 7 wherein said filament (5) is a monofilament.

9. The high speed coaxial contact and signal transmission element according to claim 7 or claims 7 and 8 wherein the impedance of said coaxial contact and signal transmission element may be varied by regulating the pitch of the winding of said filament (5).

10. The high speed coaxial contact and signal transmission element according to any of the preceding claims 1 to 9 wherein said low dielectric constant material comprises polyimide, PTFE and mineral fibers.

11. The high speed coaxial contact and signal transmission element according to any of the preceding claims 1 to 10 wherein said metal shell (3) and said metal shield (6) comprise Ag and Cu.

## Patentansprüche

1. Schnelles Koaxialkontakt- und Signalübertragungselement, umfassend:
- ein inneres Leiterelement (1),
- ein äußeres Leiterelement (6) und
- einen dielektrischen Bereich (4) zwischen dem genannten inneren (1) und dem genannnten äußeren Leiterelement (6), wobei das genannte äußere Leiterelement (6) aus einer Metallabschirmung besteht und das genannte innere Leiterelement (1) ein kontinuierliches Element ist und einen Kern aus leitendem Material umfasst, das gute elastische Eigenschaften zeigt, dadurch gekennzeichnet, dass der genannte innere Leiter aus einem Kern eines gehärteten, leitenden Materials besteht, das gute elastische Eigenschaften zeigt, und von einer Metallhülle (3) umgeben ist, und dass ein Faden (5) aus einem Material mit niedriger Dielektrizitätskonstanten um das innere Leiterelement (1) gewickelt und auf der Oberfläche des inneren Leiterelementes (1) befestigt ist.

2. Schnelles Koaxialkontakt- und Signalübertragungselement nach Anspruch 1, bei dem das genannte Koaxialkontakt- und Signalübertragungselement einen Gesamtdurchmesser von kleiner als 0,6 mm aufweist und eine Impedanz von 50 Ohm oder 70 Ohm.

3. Schnelles Koaxialkontakt- und Signalübertragungselement gemäß Anspruch 1 oder 2, bei dem das genannten innere Leiterelement (1) geeignet ist für das direkte Kontaktieren eines Bausteins (7), der durch das genannte schnelle Koaxialkontakt- und Signalübertragungselement zu testen ist.

4. Schnelles Koaxialkontakt- und Signalübertragungselement gemäß irgendeinem der vorhergehenden Ansprüche 1 bis 3, bei dem der genannte kontinuierliche Kern (2) einen Durchmesser von kleiner als 0,060 mm aufweist.

5. Schnelles Koaxialkontakt- und Signalübertragungselement gemäß irgendeinem der vorhergehenden Ansprüche 1 bis 4, bei dem der genannte kontinuierliche Kern (2) eine Härte im Bereich von 1400 N/mm² bis 1600 N/mm² aufweist

6. Schnelles Koaxialkontakt- und Signalübertragungselement gemäß irgendeinem der vorhergehenden Ansprüche 1 bis 5, bei dem das genannte gehärtete leitende Material CuBe2 enthält.

7. Schnelles Koaxialkontakt- und Signalübertragungselement gemäß irgendeinem der vorhergehenden Ansprüche 1 bis 6, bei dem der genannte Faden (5) wendelförmig um das genannte innere Leiterlement (1) gewickelt ist.

8. Schnelles Koaxialkontakt- und Signalübertragungselement gemäß irgendeinem der vorhergehenden Ansprüche 1 bis 7, bei dem der genannte Faden (5) ein Einzelfaden ist.

9. Schnelles Koaxialkontakt- und Signalübertragungselement gemäß Anspruch 7 oder den Ansprüchen 7 und 8, bei dem die Impedanz des genannten Koaxialkontakt- und Signalübertragungselementes durch Anpassen der Steigung der Wicklung des genannten Fadens (5) geändert werden kann.

10. Schnelles Koaxialkontakt- und Signalübertragungselement gemäß irgendeinem der vorhergehenden Ansprüche 1 bis 9, bei dem das genannte Material mit niedriger Dielektrizitätskonstanten Polyimide, PTFE und Mineralfasern umfasst.

11. Schnelles Koaxialkontakt- und Signalübertragungselement gemäß irgendeinem der vorhergehenden Ansprüche 1 bis 10, bei dem die genannte Metallhülle (3) und die genannte Metallabschirmung (6) Ag und Cu enthalten.

## Revendications

1. Élément de contact coaxial et de transmission de signaux à haute vitesse comprenant :
- un élément conducteur interne (1),
- un élément conducteur externe (6) et
- une zone diélectrique (4) entre ledit élément conducteur interne (1) et ledit élément conducteur externe (6), ledit élément externe consistant en un blindage métallique, ledit élément conducteur interne (1) étant un élément continu et comprenant un noyau (2) en matériau conducteur présentant de bonnes propriétés élastiques, caractérisés en ce que ledit conducteur interne est composé d'un noyau en matériau conducteur durci présentant de bonnes propriétés élastiques, entouré par une enveloppe métallique (3), et qu'un filament (5) en matériau à faible constante diélectrique est enroulé autour du dit élément conducteur interne (1) et fixé à la surface de l'élément conducteur interne (1).

2. Élément de contact coaxial et de transmission de signaux à haute vitesse selon la revendication 1 où, ledit élément de contact coaxial et de transmission de signaux a un diamètre total inférieur à 0,6 mm et une impédance de 50 ohms ou 70 ohms.

3. Élément de contact coaxial et de transmission de signaux à haute vitesse selon la revendication 1 ou 2, où ledit élément conducteur interne (1) convient pour établir un contact directement avec un dispositif (7) devant être testé par ledit élément de contact coaxial et de transmission de signaux à haute vitesse.

4. Élément de contact coaxial et de transmission de signaux à haute vitesse selon l'une quelconque des revendications 1 à 3 précédentes, où ledit noyau continu (2) a un diamètre inférieur à 0,060 mm.

5. Élément de contact coaxial et de transmission de signaux à haute vitesse selon l'une quelconque des revendications 1 à 4 précédentes où ledit noyau continu (2) a une dureté comprise entre 1400 N/mm² et 1600 N/mm².

6. Élément de contact coaxial et de transmission de signaux à haute vitesse selon l'une quelconque des revendications 1 à 5 précédentes, où ledit matériau conducteur durci est CuBe2.

7. Élément de contact coaxial et de transmission de signaux à haute vitesse selon l'une quelconque des revendications 1 à 6 précédentes où ledit filament (5) est enroulé en spirale autour du dit élément conducteur interne (1).

8. Élément de contact coaxial et de transmission de signaux à haute vitesse selon l'une quelconque des revendications 1 à 7 précédentes où ledit filament (5) est un monofilament.

9. Élément de contact coaxial et de transmission de signaux à haute vitesse selon la revendication 7 ou selon les revendications 7 et 8, où l'impédance du dit élément de contact coaxial et de transmission de signaux peut être modifiée en réglant l'écartement de l'enroulement du dit filament (5).

10. Élément de contact coaxial et de transmission de signaux à haute vitesse selon l'une quelconque des revendications 1 à 9 précédentes où ledit matériau à faible constante diélectrique comprend un polyimide, du PTFE et des fibres minérales.

11. Élément de contact coaxial et de transmission de signaux à haute vitesse selon l'une quelconque des revendications 1 à 10 précédentes où ladite enveloppe métallique (3) et ledit blindage métallique (6) sont en Ag et Cu.
